# EUROPÄISCHE PATENTANMELDUNG

(11) **EP 0 911 961 A1**
(43) Veröffentlichungstag der Anmeldung: **28.04.1999**
(21) Anmeldenummer: 98111891.2
(22) Anmeldetag: 26.06.1998
(51) Int. Cl.: H03B 9/10, H01J 23/15, H03H 1/00, H05B 6/76

(54) **Zusatzbeschaltung für ein Magnetron**

(30) Priorität: 23.10.1997 DE 19746884
(71) Anmelder: BSH Bosch und Siemens Hausgeräte GmbH, 81669 München (DE)
(72) Erfinder: Dengler, Klaus, Dipl.-Ing., 83471 Schönau am Königsee (DE); Stein, Uwe, 02977 Hogerswerda (DE)

(57) **Zusammenfassung**

Zusatzbeschaltung für ein Magnetron zur Reduzierung der Störspannungsabstrahlung, durch welche das Störspannungsverhalten des Magnetrons durch eine versorgungsspannungsseitige Schaltungseinheit minimiert wird, wobei die Beschaltungseinheit ein spezielles Ultrahochfrequenz-Störspannungsfilter darstellt.

## Beschreibung

Die Erfindung bezieht sich auf eine Zusatzbeschaltung für ein Magnetron zur Reduzierung der Störspannungsabstrahlung.

Derzeitige Mikrowellengeräte enthalten als Energiespender standardisierte Magnetrons, die eingangsmäßig eine Anschlußbox besitzen, ausgangsseitig eine Antenne. Mikrowellengeräte werden auf Mikrowellendichtheit und Störspannungssicherheit geprüft. In jüngster Zeit haben moderne Meßmethoden ergeben, daß die meisten Mikrowellengeräte Störspannungsaussendungen bis zu einem GHz auslösen, wobei die damit verbundenen Energiedichten zugelassene Werte überschreiten. So werden im Frequenzspektrum von 240 MHz bis 923 MHz durchschnittlich 35 Dezibel Störungsamplituden, gemessen in mV/m, registriert.

Aufgabe der Erfindung ist es daher, den Störspannungspegel am Spannungsversorgungsteil des Magnetrons möglichst zu beseitigen. Die erfindungsgemäße Anordnung zur Lösung dieser Aufgabe ist dadurch gekennzeichnet, daß das Störspannungsverhalten des Magnetrons durch eine versorgungsspannungsseitige Beschaltungseinheit minimiert wird, wobei die Beschaltungseinheit ein spezielles Störspannungsfilter für Ultra-Hochfrequenz darstellt.

Eine weitere vorteilhafte Ausgestaltung der Erfindung besteht darin, daß die Beschaltungseinheit ein gekammert aufgebautes Störspannungsfilter ist, bestehend aus L-C-Kombinationen, die in Baueinheit mit dem Magnetron verbunden sind.

Weitere vorteilhafte Ausgestaltungen der Erfindung sind in den Unteransprüchen enthalten. Ein Ausführungsbeispiel nach der Erfindung ist im folgenden anhand der Zeichnung näher beschrieben.

Es zeigt:
- Fig. 1: den Stand der Schaltungstechnik,
- Fig. 2: eine Ausführung mit gekammerter Zusatzbeschaltung und
- Fig. 3: eine spezifizierte gekammerte Ausführung der Zusatzbeschaltung.

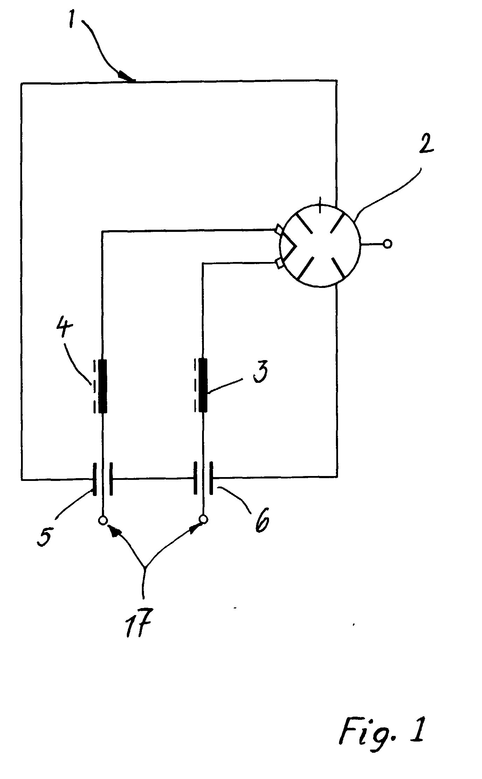

Gemäß Fig. 1 ist eine Magnetron-Anschlußbox 1, ein Magnetron 2, Induktivitäten 3, 4, Durchführungskondensatoren 5, 6 und ein Eingang zur Spannungsversorgung des Magnetrons 17 dargestellt. Das in der Magnetron-Anschlußbox 1 befindliche L-C-Störspannungsfilter läßt eine Störungsamplitude in Abhängigkeit von der Frequenz gemäß Tabelle zu, wobei auffällt, daß insbesondere bei den Frequenzen um 500 MHz eine größere Störspannungsamplitude auftritt.

| | | | | | | | | |
|---|---|---|---|---|---|---|---|---|
| Frequenz[MHz] | 240 | 280 | 492 | 546 | 615 | 738 | 875 | 923 |
| Störung vor Änderung [dB(µV/m)] | 32,5 | 39,5 | 30 | 45,5 | 53,5 | - | 37 | - |
| Störung nach Änderung [dB(µV/m)] | - | - | - | - | - | - | - | - |

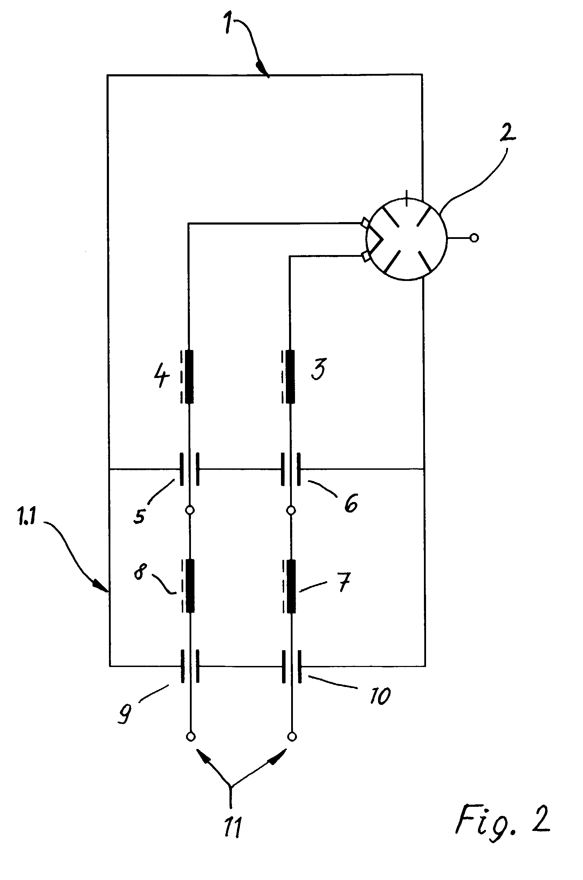

Diese Werte gemäß Tabelle überschreiten die Zulässigen Störspannungsamplituden beträchtlich. Eine Ausführungsform der erfindungsgemäßen Anordnung zeigt Fig. 2. Die Schaltungsanordnung gemäß Fig. 2 zeigt zwei Anschlußboxen bzw. Störspannungsfilterkammern, die in relativ gleicher Bauweise nebeneinander angeordnet sind und dabei entweder miteinander verschraubt oder verschweißt sind.

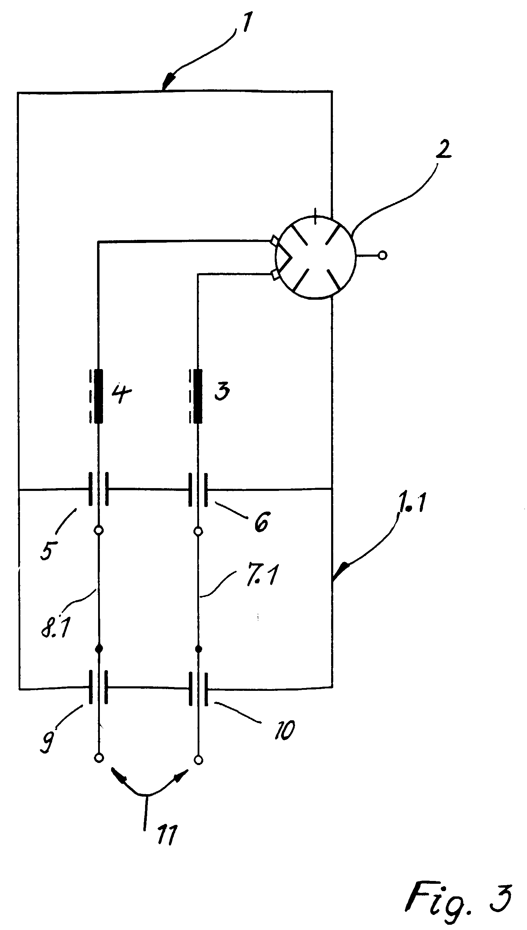

Gemäß Fig. 2 ist die Magnetron-Anschlußbox 1 und die Kammer für das Störspannungsfilter 1.1 als Gehäuse für die Störspannungsschaltung entnehmbar. Die Anordnung gemäß Fig. 1 ist mit den zusätzlichen Induktivitäten 7, 8 und den Durchführungskondensatoren 9, 10 direkt beschaltet, wobei der Spannungsversorgungseingang 11 für das Magnetron am Ausgang der Kammer für das Störspannungsfilter angeordnet ist. Das zusätzliche Filter entspricht dem Aufbau und der Funktion der Anschlußbox des Magnetrons. Die Enden der beiden Drosseleinheiten (Induktivitäten) 8, 7 wurden direkt an den Ausgang des Durchführungskondensators des Magnetrons angeschlossen. Die Messung der Störaussendungen unterhalb einem GHz erfolgte mit verschlossener Anschlußbox. Dabei sind die Daten der Tabelle zu entnehmen (s. Seite 2). Es ist erkennbar, daß nach Anordnung des Störspannungsfilters in der dafür vorgesehenen Kammer 1.1 keine meßbare Störspannungsamplitude auftrat. Damit waren im Frequenzbereich unterhalb einem GHz keine Störspannungsamplituden nachweisbar. Aufgrund dieser Messung ist es naheliegend, gekammerte Störspannungsfilter dem jeweiligen Spannungsversorgungsteil der standardisierten Magnetroneinheiten vorzuschalten. Es ist bewiesen, daß das Störspannungsverhalten des Magnetrons durch eine versorgungsspannungsseitige Beschaltungseinheit minimiert wird, wobei die Beschaltungseinheit ein spezielles Ultrahochfrequenz-Störspannungsfilter darstellt, das in seiner Einheit aus einem L-C-Glied und einer gekammerten Ummantelung desselben besteht. Diese Beschaltungseinheit als gekammert aufgebautes Störspannungsfilter ist mit dem Magnetron in Baueinheit verbunden und je nach Verbindungstechnik verschraubt oder verschweißt (punktgeschweißt). Als zweckmäßig für effektive Störspannungsfilterwerte haben sich Induktivitätswerte von ungefähr 1 µH und Kapazitätswerte der Durchführungskondensatoren von ca. 500 pF herausgestellt. Eine andere Ausführung der erfindungsgemäßen Lösung ist gemäß Fig. 3 dargestellt. Die Schaltungsvariante gemäß Fig. 3 unterscheidet sich gegenüber der erfindungsgemäßen Variante nach Fig. 2 dadurch, daß die Induktivitäten 7,8 ersetzt sind durch Leiterstücken 7.1 und 8.1. Diese Leiterstücke besitzen bei hohen Frequenzen eine Induktivität, die im Verhältnis zur diskret angeordneten Induktivität etwa wie 1:10 anzusetzen ist. Infolge des gekammerten Aufbaues des Störspannungsfilters wirkt die durch die Leitungsinduktivitäten und die Durchführungskondensatoren gebildete Schaltungsanordnung wie ein breitbandigeres Störspannungsfilter, wobei Messungen ergaben, daß nur unwesentliche Verschlechterungen gegenüber der Schaltungsvariante gemäß Fig. 2 anzusetzen sind.

Die Vorteile der erfindungsgemäßen Anordnung liegen zweifelsfrei darin, daß die Störspannungsfilter nach der erfindungsgemäßen Anordnung eine störspannungsfreie Belegung des Magnetron-Versorgungsspannungseinganges ergeben. Damit sind keine Störspannungsabstrahlungen unterhalb einem GHz meßbar, wodurch die verschärften Anforderung an Störspannungsabstrahlungswerte garantiert sind.

## Patentansprüche

1. Zusatzbeschaltungsanordnung für ein Magnetron (2) mit einer Anschlußbox (1), in der ein Störspannungsfilter (3, 4, 5, 6) angeordnet ist, zur Reduzierung der Störspannungsabstrahlung, **dadurch gekennzeichnet, daß** die Anschlußbox (1) versorgungsspannungsseitig mit einem Zusatzstörspannungsfilter (7, 8, 9, 10; 7.1, 8.1, 9, 10) verbunden ist, das in einer Zusatzanschlußbox (1.1) gekammert ist.

2. Zusatzbeschaltungsanordnung nach Anspruch 1, **dadurch gekennzeichnet,** daß diese ein gekammert aufgebautes Störspannungsfilter ist, bestehend aus L-C-Kombinationen, die in Baueinheit mit dem Magnetron verbunden sind.

3. Zusatzbeschaltungsanordnung nach Anspruch 1 oder 2, **dadurch gekennzeichnet,** daß die L-C-Kombinationen des Störspannungsfilters von Induktivitätswerten von ungefähr 1 µH und Kapazitätswerten der Durchführungskondensatoren von ca. 500 pF gebildet werden.

4. Zusatzbeschaltungsanordnung nach Anspruch 1, 2 oder 3, **dadurch gekennzeichnet,** daß die Zusatzanschlußbox (1.1) und die Anschlußbox (1) des Magnetrons (2) elektrisch leitend verbunden, insbesondere verschraubt sind.

5. Zusatzbeschaltungsanordnung nach Anspruch 1, 2 oder 3, **dadurch gekennzeichnet,** daß die Zusatzanschlußbox (1.1) und die Anschlußbox (1) des Magnetrons (2) elektrisch leitend verbunden, insbesondere verschraubt sind.
